# EUROPEAN PATENT APPLICATION

(11) **EP 1 091 400 A1**
(43) Date of publication of application: **11.04.2001**
(21) Application number: 99949311.7
(22) Date of filing: 15.10.1999
(51) Int. Cl.: H01L 21/66

(54) **WAFER PROBER**

(30) Priority: 15.07.1999 JP 20178999
(71) Applicant: IBIDEN CO., LTD., Ogaki-shi Gifu-ken 503-0917 (JP)
(72) Inventor: ITO, Atsushi, Ibi-gun, Gifu 501-0695 (JP); HIRAMATSU, Yasuji, Ibi-gun, Gifu 501-0695 (JP); ITO, Yasutaka, Ibi-gun, Gifu 501-0695 (JP); FURUKAWA, Masakazu, Ibi-gun, Gifu 501-0695 (JP)
(74) Representative: Nevant, Marc
(86) International application number: JP9905693
(87) International publication number: WO0106559

(57) **Abstract**

This invention has its objects to provide a wafer prober which is lightweight, excellent in thermal response kinetics and free from warpage upon pressing with a probe card, thus capable of effective protecting itself against damage to the silicon wafer and measurement error.

This invention is related to a wafer prober wherein a ceramic substrate is formed with a conductor layer on its surface.

## Description

### TECHNICAL FIELD

The present invention relates to a wafer prober for use chiefly in semiconductor industry, and more particularly a wafer prober which is thin and lightweight and has a good thermal response kinetics.

### BACKGROUND ART

The semiconductor is a product of great importance to various industries and the semiconductor chip is manufactured by, for example, slicing a silicon single crystal to a predetermined thickness to prepare a silicon wafer and constructing various circuits on the wafer.

The process for producing such a semiconductor chip must include a probing step for checking, in the silicon wafer stage, whether various electrical characteristics will be materialized as designed and the so-called prober is used for this purpose.

As such probers, Japanese Patent Publication 2587289, Japanese Kokoku Publication Hei-3-40947 and Japanese Kokai Publication Hei-11-31724, among others, describe wafer probers each equipped with a metallic chuck top comprising aluminum alloy, stainless steel or the like [Fig. 13].

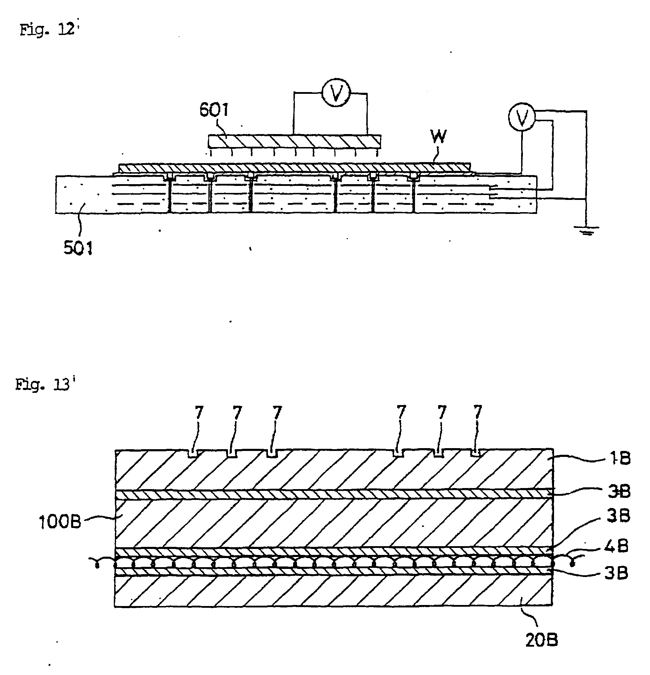

With such a wafer prober, as illustrated in Fig. 12, for instance, silicon wafer W is set on the wafer prober 501, the probe card 601 having tester pins is pressed against the silicon wafer W, and then an electric voltage is applied under heating and cooling to perform a conductivity test.

However, any wafer prober equipped with such a metallic chuck top was found to have the following drawbacks.

In the first place, because it comprises a metal, the chuck top is, of necessity, as thick as approximately 15 mm. Such a thickness is needed for chuck top because if it is formed with a thin metal sheet, the chuck top will warp or be strained as it is pressed by the tester pins of the prober card, with the result that the silicon wafer disposed on the metal sheet tends to be damaged or tipped.

Therefore, the chuck top must be sufficiently increased in thickness but doing so results in increased weight and bulk.

Moreover, despite the use of a metal having a high thermal conductivity, the thermal response kinetics are poor, that is to say the temperature of the chuck top sheet does not quickly follow the change in voltage or current so that the temperature can hardly be controlled and, when a silicon wafer is set thereon at a high temperature, is quite uncontrollable.

### SUMMARY OF THE INVENTION

In the light of the above state of the art, the present invention has for its object to provide a wafer prober which is lightweight, excellent in thermal response kinetics and free from warpage upon pressing with a probe card, thus capable of effective protecting itself against damage to the silicon wafer and measurement error.

To accomplish the above object, the inventors of the present invention made intensive investigations and found that when a high-rigidity ceramic material is provided with a conductor layer for use as a chuck top conductor layer in lieu of a metallic chuck top, there is obtained a wafer prober which is thin and yet free from the trouble of warpage.

Furthermore, the inventors discovered that the poor thermal response characteristic of the wafer prober having a metallic chuck top despite the use of a metal of high thermal conductivity is because the thickness of the metal sheet is too great as a result that the sheet has high heat capacity and the inventors arrived at the novel technical concept, which is diametrically opposite to the common belief, that even though its thermal conductivity is inferior to metal, the use of a ceramic material is conducive to decrease in heat capacity by reducing the thickness of it, thus realizing improvements in thermal response kinetics. The present invention has come forth from the above finding.

The present invention, therefore, is directed to a wafer prober which comprises a ceramic substrate and a conductor layer (chuck top conductor layer) formed on the surface thereof.

In said wafer prober, said ceramic substrate is preferably equipped with a temperature control means.

In said wafer prober, said ceramic substrate is preferably composed of at least one member selected from the group essentially consisting of nitride ceramics, carbide ceramics and oxide ceramics.

Moreover, said temperature control means is preferably a Peltier device or a heating element.

Further, in said wafer prober, said ceramic substrate preferably has at least one or more conductor layers therein, with its surface preferably being formed with channels.

Furthermore, the channels provided with air suction holes are preferably formed on the surface of said ceramic substrate.

### BRIEF DESCRIPTION OF THE DRAWINGS

Fig. 1 is a schematic cross-section view showing an example of the wafer prober according to the present invention.
Fig. 2 is a plan view of the wafer prober shown in Fig. 1.
Fig. 3 is a bottom view of the wafer prober shown in Fig. 1.
Fig. 4 is a sectional elevation view taken along the line A-A of Fig. 1.
Fig. 5 is a schematic cross-section view showing another example of the wafer prober according to the present invention.
Fig. 6 is a schematic cross-section view showing still another example of the wafer prober according to the present invention.
Fig. 7 is a schematic cross-section view showing another example of the wafer prober according to the present invention.
Fig. 8 is a schematic cross-section view showing the wafer prober of the present invention as assembled with a platform.
Fig. 9 (a) is a schematic longitudinal section view of the wafer prober of the present invention as assembled with another platform and Fig. 9 (b) is a sectional view taken along the line B-B of (a).
Fig. 10 (a) to (d) are schematic cross-section views illustrating several stages of the process for manufacturing the wafer prober according to the present invention.
Fig. 11 (e) to (g) are schematic cross-section views illustrating several stages of the process for manufacturing the wafer prober according to the present invention.
Fig. 12 are schematic cross-section views illustrating the conductivity test performed with the wafer prober of the present invention.
Fig. 13 is a schematic cross-section view illustrating a conventional wafer prober.

### EXPLANATION OF THE NUMERIC SYMBOLS

101, 201, 301, 401 wafer prober
2 chuck top conductor layer
3 ceramic substrate
5 guard electrode
6 ground electrode
7 channel
8 suction hole
10 heat insulator
11 platform
12 blow-out nozzle
13 suction port
14 cooling medium injection port
15 prop
16, 17 through hole
180 blind holes
19, 190, 191 external terminal pin
41, 42 heating element
410 protective layer
43 metal wire
44 Peltier device
440 thermoelectronic element
441 ceramic substrate
51 conductive layer
52 non-conductor layer-forming areas

### DETAILED DESCRIPTION OF THE INVENTION

The present invention is now described in detail.

The wafer prober of the present invention comprises a ceramic substrate and a conductor layer (chuck top conductor layer) on the surface thereof. This conductor layer will hereinafter be referred to as "chuck top conductor layer".

Since a high-rigidity ceramic substrate is used in the present invention, the chuck top does not undergo warpage when pressed by the tester pins of a probe card so that the thickness of said chuck top may be smaller than the metallic chuck top.

Furthermore, because the thickness of said chuck top can thus be reduced in comparison with a metallic chuck top, the thermal response kinetics of the wafer prober can be improved as the heat capacity is decreased despite the comparatively low thermal conductivity of ceramics as compared with metals.

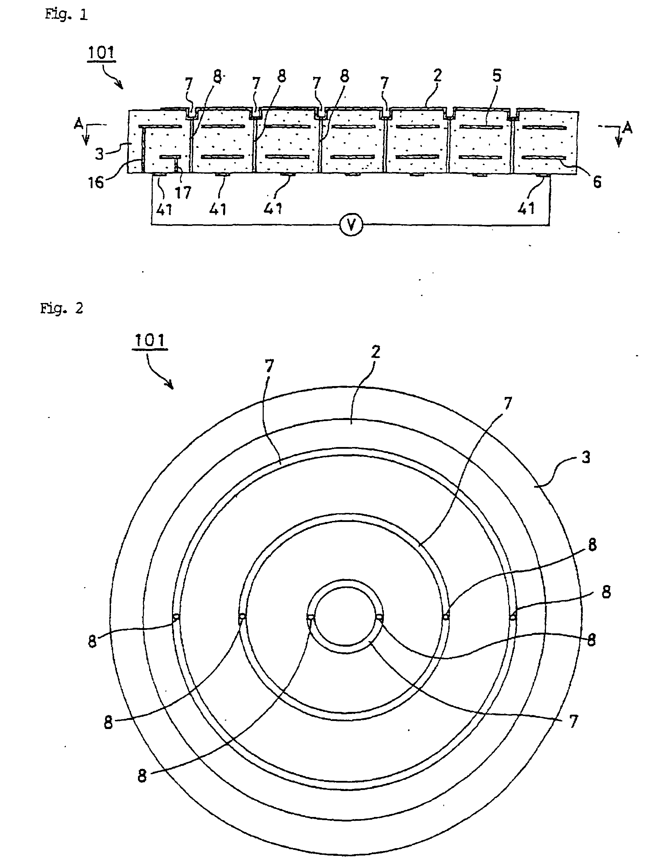

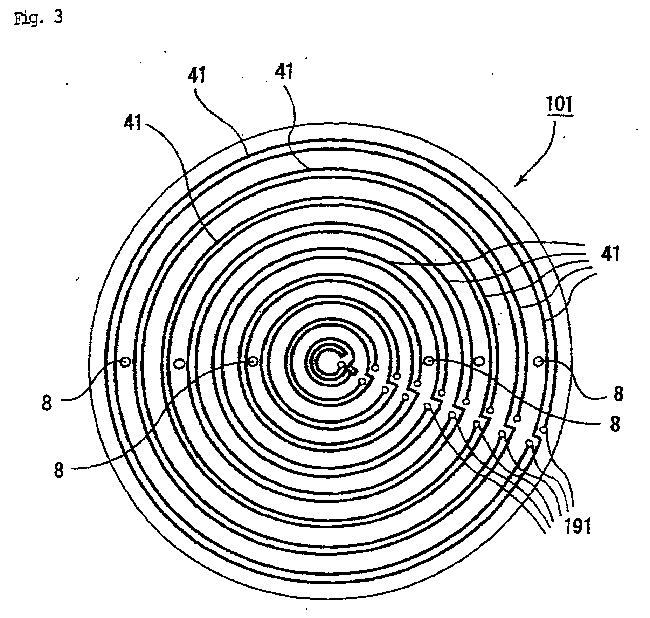

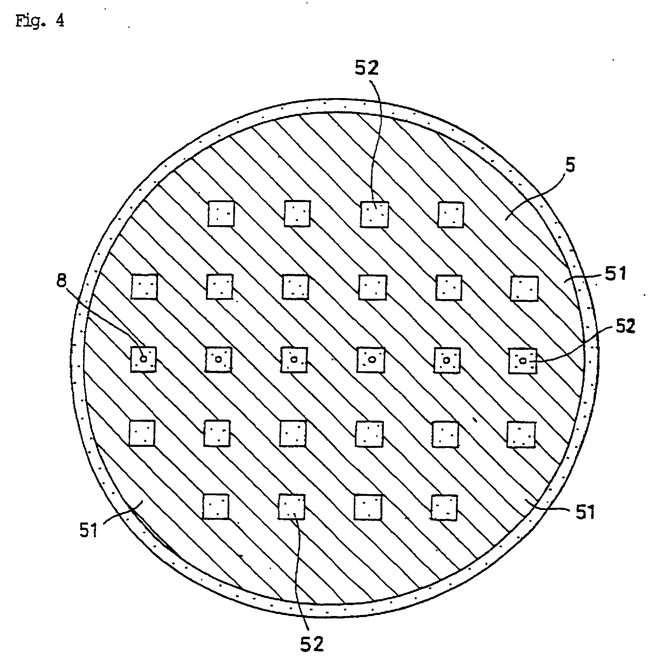

Fig. 1 is a schematic cross-section view showing one example of the wafer prober of the present invention; Fig. 2 is a plan view thereof; Fig. 3 is a bottom view thereof; and Fig. 4 is a sectional view taken along the line A-A of Fig. 1.

This wafer prober comprises a ceramic substrate 3 which is circular in plan view and has a plurality of concentric channels 7 formed on its surface, and a plurality of suction holes 8 for attracting a silicon wafer by suction as formed strategically in a part of said channels 7 and a chuck top conductor layer 2 formed in a circular fashion for connection to electrodes of a silicon wafer as covering most of said ceramic substrate 3 inclusive of said channels 7.

On the other hand, the bottom surface of the ceramic substrate 3 is provided, as shown in Fig. 3, with a plurality of coils of a heating element 41 in a concentric array in plan view for controlling the temperature of the silicon wafer, with both ends of said coils of heating element 41 being secured to an external terminal pin 191. In addition, a guard electrode 5 and a ground electrode 6 are disposed in said ceramic substrate 3 for avoiding stray capacitance and noise.

The wafer prober of the present invention may assume, for example, the structures illustrated in Figs. 1 to 4. In the following, each component of said wafer prober and other examples of the wafer prober of the present invention will be described serially in detail.

The ceramic substrate for use in the wafer prober of the present invention is preferably at least one member selected from the group essentially consisting of nitride ceramics, carbide ceramics and oxide ceramics.

The nitride ceramics mentioned above includes metal nitride ceramics such as aluminum nitride, silicon nitride, boron nitride and titanium nitride ceramics, among others.

The carbide ceramics mentioned above includes metal carbide ceramics such as silicon carbide, zirconium carbide, titanium carbide, tantalum carbide and tungsten carbide ceramics, among others.

The oxide ceramics mentioned above includes metal oxide ceramics such as alumina, zirconia, cordierite and mullite ceramics, among others.

Those ceramics can be used each independently or in combination.

Among these ceramics, nitride ceramics and carbide ceramics are preferred to oxide ceramics because the former ceramics are superior in thermal conductivity.

Moreover, among nitride ceramics, aluminum nitride ceramics is the best choice because it has the highest thermal conductivity of 180 W/m·K.

The ceramics mentioned above preferably contain 200 to 1000 ppm of carbon. This is partly because the electrode pattern of the ceramic substrate can be hidden and partly because a high radiant heat can be obtained. The carbon may be a crystalline carbon which can be detected by X-ray diffraction analysis or an amorphous carbon which cannot be so detected;

The thickness of the ceramic substrate of the chuck top of the present invention should be greater than the thickness of the chuck top conductor layer and, to be concrete, is preferably within the range of 1 to 10 mm.

Since the reverse side of the silicon wafer is utilized as the electrode in the present invention, the ceramic substrate is formed with a chuck top conductor layer on its surface.

The thickness of said chuck top conductor layer is preferably 1 to 20 µm. If the conductor layer is less than 1 µm in thickness, its resistance will be too high as a result that the layer cannot function as an electrode. On the other hand, if the thickness exceeds 20 µm, the layer will be liable to peel off due to the stress of the conductor.

The chuck top conductor layer can be constructed using at least one kind of metal selected from among high-melting metals such as copper, titanium, chromium, nickel, noble metals (e.g. gold, silver and platinum), tungsten and molybdenum.

The chuck top conductor layer may be a porous layer of metal or conductive ceramics. In the case of a porous layer, it is unnecessary to provide channels for attraction by suction as will be described later, so that the destruction of the wafer owing to the presence of such channels can be precluded and a uniform attraction by suction over the entire surface can be realized.

As such a porous material, a sintered metal can be used.

The porous material can be used in a thickness of 1 to 200 µm. The porous material can be secured to the ceramic substrate by soldering or brazing.

The chuck top conductor layer preferably contains nickel. This is because such a layer is so hard that it is not easily deformed by the pressing force of the tester pins.

A specific example of the chuck top conductor layer is a conductor layer constructed by sputtering nickel and then forming an electroless plated nickel layer thereon or a conductor layer constructed by sputtering titanium, molybdenum and nickel in that order and further depositing nickel in superimposition by electroless plating or electroplating.

The conductor layer may also be a layer constructed by sputtering titanium, molybdenum and nickel in that order and further depositing copper and nickel serially, both by electroless plating. The formation of a copper layer contributes to a reduced resistance value of the chuck top electrode.

A further alternative conductor layer may be a conductor layer formed by sputtering titanium and copper in that order and further depositing nickel thereon by electroless plating or electroplating.

Furthermore, it is possible to construct a conductor layer by sputtering chromium and copper in that order and then depositing nickel in superimposition by electroless plating or electroplating.

Titanium and chromium, mentioned above, contribute to improved adhesion of the conductor layer to ceramics, while molybdenum insures better adhesion to nickel.

The preferred thickness of titanium and chromium layers is 0.1 to 0.5 µm, that of molybdenum is 0.5 to 7.0 µm, and that of nickel is 0.4 to 2.5 µm.

Said chuck top conductor layer is preferably formed with a noble metal layer (gold, silver, platinum or palladium) on its surface, because the noble metal layer prevents contamination due to migration of base metals. The preferred thickness of said noble metal layer is 0.01 to 15 µm.

In the present invention, the ceramic substrate is preferably provided with a temperature control means, because a conductivity test of the silicon wafer may then be performed under heating and cooling.

The temperature control means is not limited to the heating element 41 shown in Fig. 1 but may be a Peltier device. When a heating element is used, the substrate may be provided with a cooling means such as orifices for blasting a cooling medium such as air.

The heating element may be disposed at a plurality of layers. In this case, the pattern at one layer is preferably complementary to the pattern at another layer so that, as viewed from the heating plane, the pattern exists at one layer or at another layer. A mutually staggered arrangement is a case in point.

The heating element may for example be a sintered metal element or a conductive ceramic element, a metal foil, and a metal wire. The preferred sintered metal is sintered tungsten and/or sintered molybdenum. Those metals are relatively hard to be oxidized and have sufficiently high resistance values necessary for heat generation.

As the conductive ceramic, tungsten carbides and/or molybdenum can be used.

When the heating element is to be formed externally of the ceramic substrate, the preferred sintered metal is a sintered noble metal (gold, silver, palladium, platinum) or nickel. To be specific, silver or silver-palladium can be used.

The form of the metal powder to be used for said sintered metal may for example be spherical, flaky or mixed spherical-flaky.

The sintered metal may contain a metal oxide added. The inclusion of metal oxide is intended to insure improved adhesion of the metal powder to nitride ceramics or carbide ceramics. The reason why said metal oxide enhances the adhesion of the metal powder to nitride or carbide ceramics is not quite clear but it is likely that the slight oxide film formed on the surface of the metal powder and the nitride or carbide ceramics are sintered together via the metal oxide to be unified so that good adhesion between the metal powder and the nitride or carbide ceramics can be insured.

The metal oxide mentioned above is preferably at least one member selected from the group consisting of lead oxide, zinc oxide, silica, boron oxide (B₂O₃), alumina, yttria and titania. The reason for use of metal oxide is that those oxides improve the adhesion between the metal powder and the nitride or carbide ceramics without increasing the resistance value of the heating element.

The proportion of the metal oxide mentioned above is preferably not less than 0.1 weight % and less than 10 weight % based on the metal powder. Within this range, the adhesion between the metal powder and the nitride or carbide ceramics can be improved without causing too much increase in resistance.

The preferred proportions of lead oxide, zinc oxide, silica, boron oxide (B₂O₃), alumina, yttria and titania, with the total amount of metal oxide being taken as 100 weight parts, are that lead oxide accounts for 1 to 10 weight parts, silica for 1 to 30 weight parts, boron oxide for 5 to 50 weight parts, zinc oxide for 20 to 70 weight parts, alumina for 1 to 10 weight parts, yttria for 1 to 50 weight parts and titania for 1 to 50 weight parts. However, it is preferred that the total of them does not exceed 100 weight parts. That is because those ranges are particularly useful for improving adhesion to nitride ceramics.

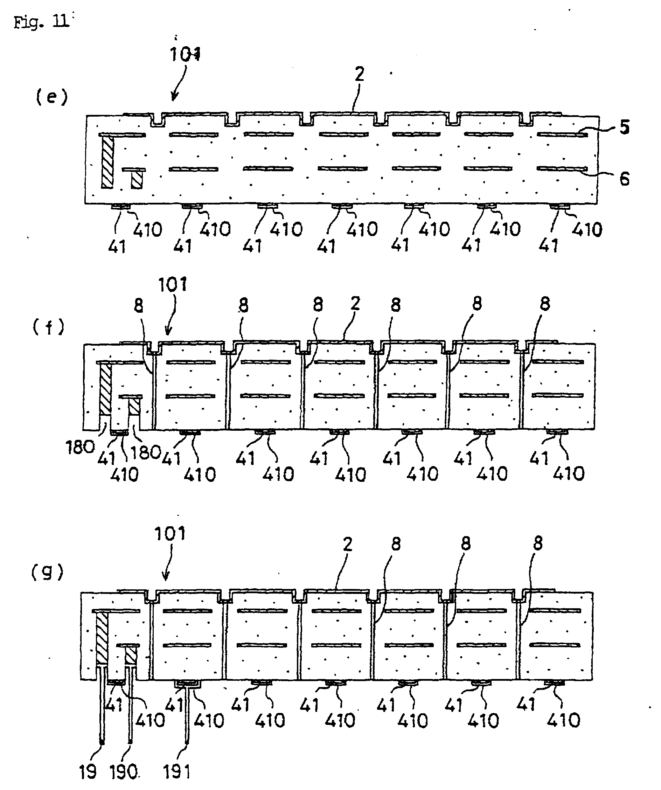

When the heating element is disposed on the surface of the ceramic substrate, the surface of the heating element is preferably covered with a metal layer 410 [Fig. 11(e)]. The heating element comprises a sintered body of metal powder and, if exposed, is liable to be oxidized to cause changes in resistance value. This oxidation can be prevented by covering the surface of the heating element with a metal layer.

The thickness of the metal layer is preferably 0.1 to 10 µm. Within this range, the oxidation of the heating element can be precluded without alteration in the resistance value of the heating element.

The metal for use in said coating may be any non-oxidizable metal. More particularly, at least one metal selected from the group consisting of gold, silver, palladium, platinum and nickel can be used with advantage. Among them, nickel is particularly preferred. This is because while the heating element must be provided with terminals for connection to a power source and those terminals are soldered to the heating element, nickel prevents thermal diffusion of the solder. As connection terminals, terminal pins comprising copal can be used.

When the heating element is formed within the heater plate, the surface of the heating element is not oxidized so that it need not be covered. When the heating element is thus formed within the heater plate, the surface of the heating element may be partially exposed.

As the metal foil for use as the heating element, a heating element formed by pattern-etching a nickel foil or a stainless steel foil is preferred.

The patterned metal foil may be bonded with resin film or the like.

As the metal wire, there can be mentioned tungsten wire, molybdenum wire and the like.

The use of a Peltier device as said temperature control means is advantageous in that both heating and cooling can be effected by changing the direction of flow of an electric current.

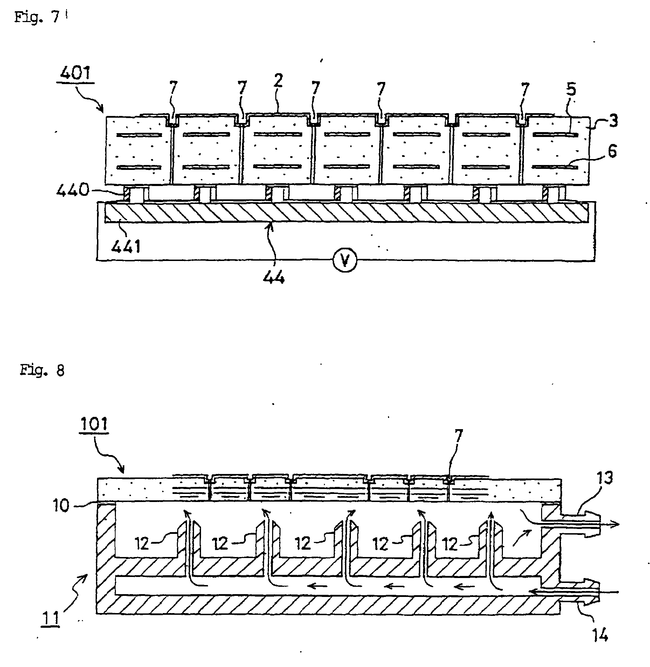

As illustrated in Fig. 7, a Peltier device is formed by connecting p and n type thermoelectric elements 440 in series and bonding them to a ceramic board 441, for instance.

As the Peltier device, there can be mentioned a silicon-germanium device, a bismuth-antimony device, and a lead-tellurium device.

In the present invention, at least one electrically conductive layer is preferably interposed between the temperature control means and the chuck top conductor layer. The guard electrode 5 and ground electrode 6 shown in Fig. 1 correspond to said conductor layers.

The guard electrode 5 is an electrode for canceling the stray capacitance in the measuring circuit and is given the earth potential of the measuring circuit (i.e. the chuck top conductor layer 2 in Fig. 1). The ground electrode 6 is provided for canceling the noise from the temperature control means.

The preferred thickness of these electrodes is 1 to 20 µm. If the electrodes are too thin, the resistance value is increased. If they are too thick, the ceramic substrate may undergo warpage or the thermal shock resistance will be decreased.

Each of said guard electrode 5 and ground electrode 6 is preferably disposed in the form of a grid as shown in Fig. 4. Thus, a multiplicity of orthogonal non-conductor layer-forming areas 52 are laid out regularly in a circular conductor layer 51. This arrangement is used for improving the adhesion between the ceramics on and underneath the conductor layer.

The surface of the chuck top layer of the wafer prober according to the present invention is preferably provided with channels 7 and air suction holes 8 as illustrated in Fig. 2. A plurality of suction holes 8 are arranged to insure a uniform suction force. By this means, after placement of a silicon wafer W, the air can be aspirated from the suction holes 8 to attract the silicon wafer W.

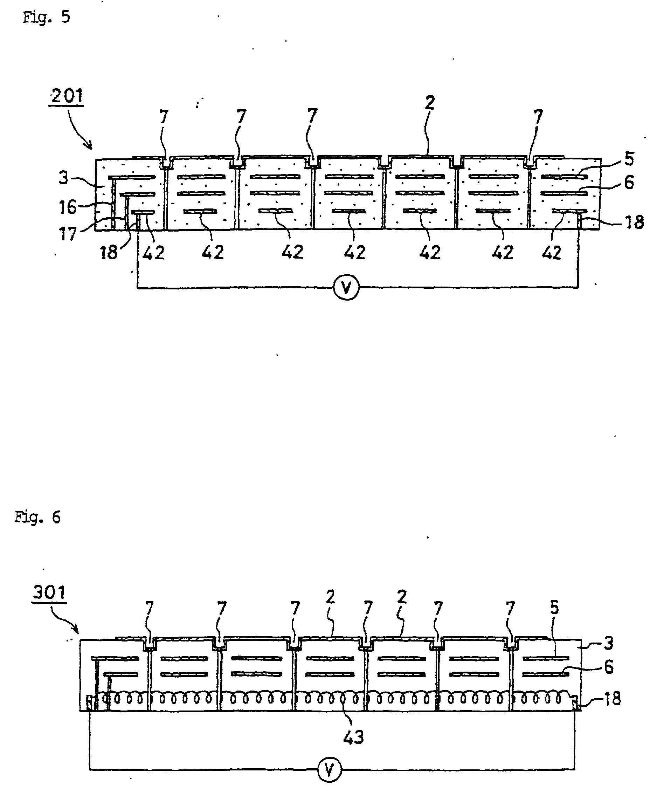

The wafer prober according to the present invention includes, for example, a wafer prober 101 which, as shown in Fig. 1, comprises a ceramic substrate 3, a heating element 41 disposed on the bottom side thereof, a chuck top conductor layer 2, and a guard electrode 5 layer and a ground electrode 6 layer interposed between the heating element 41 and chuck top conductor layer 2; a wafer prober 201 which, as shown in Fig. 5, comprises a ceramic substrate 3, a flat heating element 42 disposed within said ceramic substrate 3, a chuck top conductor layer 2, and a guard electrode 5 and a ground electrode 6 interposed between said heating element 42 and chuck top conductor layer 2; a wafer prober 301 which, as shown in Fig. 6, comprises a ceramic substrate 3, a metal wire 43 constituting a heating element as embedded in said ceramic substrate 3, a chuck top conductor layer 2, and a guard electrode 5 and a ground electrode 6 interposed between said metal wire 43 and chuck top conductor layer 2; and a wafer prober 401 which, as shown in Fig. 7, comprises a ceramic substrate 3, a Peltier device 44 (comprising thermoelectric elements 40 and a ceramic substrate 441) formed externally of said ceramic substrate 3, a chuck top conductor layer 2, and a guard electrode 5 and a ground electrode 6 as interposed between said Peltier device 44 and chuck top conductor layer 2. All the wafer probers mentioned above have channels 7 and suction holes 8 as essential component structures.

In the present invention, as shown in Figs. 1 to 7, heating elements 42 and 43 are formed within the ceramic substrate 3 [Figs. 5 and 6] and the guard electrode 5 and ground electrode 6 [Figs. 1 to 7] are also formed within the ceramic substrate 3, so that connecting members (plated-through holes) 16, 17 and 18 for electrically connecting them to external terminals are required. The plated-through holes 16, 17 and 18 are formed by filling with a high-melting metal paste such as a tungsten paste or molybdenum paste or a conductive ceramic such as tungsten carbide or molybdenum carbide.

The preferred diameter of the connecting members (plated-through holes) 16, 17 and 18 is 0.1 to 10 mm. This is because cracking and strains can be prevented while disconnection is prevented.

Using the plated-through holes as connecting pads, external pins are connected [Fig. 11(g)].

The connections are formed by soldering or brazing. The brazed material includes brazed silver, brazed palladium, brazed aluminum, and brazed gold, among others. The preferred brazed gold is Au-Ni alloy. This is because Au-Ni alloy shows good adhesion to tungsten.

The Au/Ni ratio is preferably [81.5 to 82.5 (wt. %)]/[18.5 to 17.5 (wt. %)].

The thickness of the Au-Ni layer is preferably 0.1 to 50 µm. This is because this range provides for the sufficient connection. Au-Cu alloy undergoes aging when it is exposed to a high temperature of 500 to 1000°C in a high vacuum of 10⁻⁶ to 10⁻⁵ Pa but Au-Ni alloy does not undergo aging under such conditions. The amount of impurity elements in the Au-Ni alloy is preferably less than 1 weight part when the total amount is taken as 100 weight parts.

In the present invention, thermocouples may be embedded in the ceramic substrate if necessary. Then, it is possible to measure the temperature of the heating element with those thermocouples and control the temperature by varying the voltage or current value according to the data.

The size of junction of the thermocouple to the metal wire is preferably not less than the bare conductor diameter of each metal wire but is not over 0.5 mm. By satisfying the above requirement, the heat capacity of the junction can be held small and consequently the temperature is accurately and quickly converted to a current value. As a result, temperature control is improved and the temperature distribution on the heating surface of the wafer is narrowed.

The thermocouple mentioned above includes, as listed in JIS C-1602 (1980), the type K, type R, type B, type S, type E, type J and type T thermocouples.

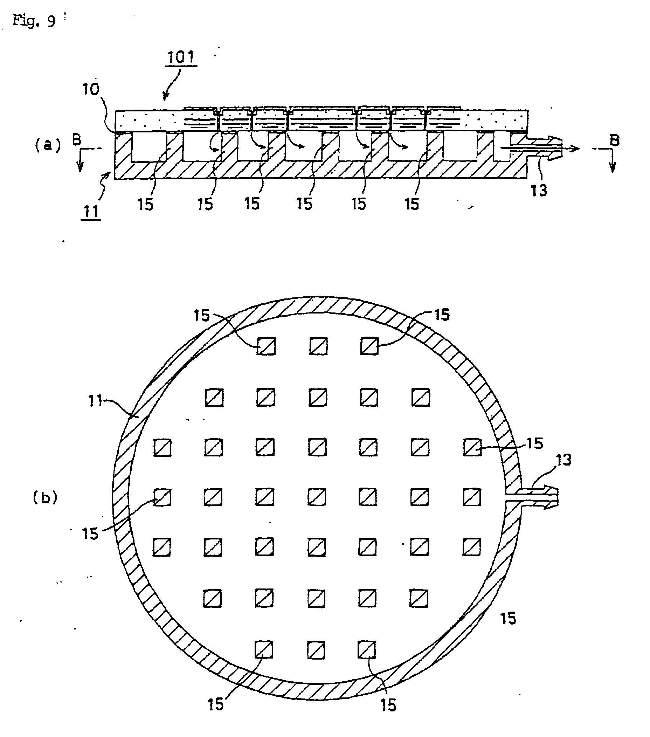

Fig. 8 is a schematic sectional view of a platform 11 for supporting the wafer prober of the present invention having the above-described construction.

This platform 11 is formed with blow-out nozzles 12 for a cooling medium and the cooling medium is admitted from a cooling medium injection port 14. Thus, the air aspirated from the suction port 13 is forced into the channels 7 via suction holes 8 to thereby attract the silicon wafer (not shown) set on the wafer prober.

Fig. 9 (a) is a schematic longitudinal section view of another platform and (b) is a sectional view taken along the line B-B of (a). As shown in Fig. 9, this platform is provided with a plurality of props 15 for preventing warpage of the wafer prober upon being pressed by the tester pins of the probe card.

The platform may comprise aluminum alloy or stainless steel.

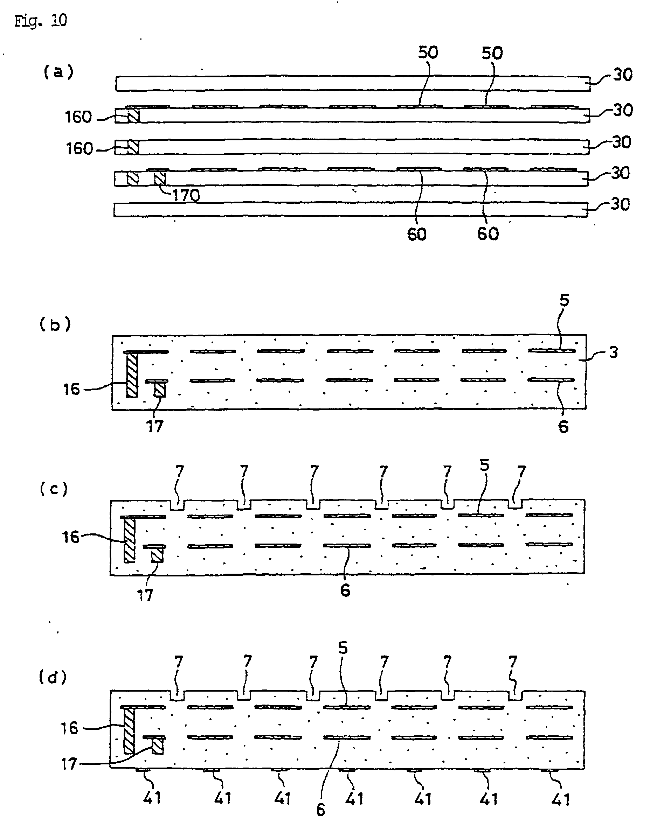

A typical process for manufacturing the wafer prober of the present invention is now described, reference being had to the sectional views in Figs. 10 and 11.
(1) First, a powder of ceramic material such as oxide ceramics, nitride ceramics and carbide ceramics is admixed and molded with a binder and a solvent to prepare a green sheet 30.
   As the ceramic powder mentioned above, a powder of aluminum nitride or silicon carbide, for instance, can be used. Where necessary, a sintering aid such as yttria can be added.
   The binder mentioned above is preferably at least one member selected from the group consisting of acrylic binder, ethylcellulose, butylcellosolve and polyvinyl alcohol.
   As the solvent, it is preferable to use at least one member selected from the group consisting of α-terpineol and glycol.
   The paste obtained by admixing the above materials is molded into a sheet by the doctor blade method to fabricate said green sheet 30.
   Where necessary, this green sheet 30 may be provided with through-holes for accepting the silicon pins of the wafer support and cavities for embedding thermocouples. The through-holes and cavities can be formed by punching, for instance.
   The preferred thickness of the green sheet 30 is about 0.1 to 5 mm.
   Then, the green sheet 30 is printed with the guard electrode and ground electrode.
   In consideration of the rate of shrinkage of the green sheet 30, this printing is performed so as to insure a predetermined aspect ratio to thereby provide a guard electrode print 50 and a ground electrode print 60.
   Those prints can be provided by using a conductive paste containing a conductive ceramic or metal powder.
   The optimum conductive ceramic powder in such a conductive paste is a powder of tungsten carbide or molybdenum carbide. This is because such powder is hardly oxidized and, hence, least liable to decrease in thermal conductivity.
   As said metal powder, a powder of, for example, tungsten, molybdenum, platinum, or nickel can be used.
   The preferred mean particle diameter of said conductive ceramic powder or metal powder is 0.1 to 5 µm. This is because, with any larger particles or smaller particles outside the above range, the paste may hardly be printed.
   The optimum paste is a compounded mixture of 85 to 97 weight parts of a metal powder or a conductive ceramic powder, 1.5 to 10 weight parts of at least one kind of binder selected from among acrylic binder, ethylcellulose, butylcellosolve and polyvinyl alcohol, and 1.5 to 10 weight parts of at least one kind of solvent selected from among α-terpineol, glycol, ethanol and butanol.
   The holes formed by punching, for instance, are filled with the conductive paste to provide plated-through hole prints 160 and 170.
   Then, as shown in Fig. 10 (a), the green sheet 30 provided with prints 50, 60, 160 and 170 is laminated with a green sheet 30 not provided with such prints. The unprinted green sheet 30 is laminated to the heating element side because the end faces of the plated-through holes will not be exposed and, hence, not oxidized in the sintering procedure for the formation of a heating element. If the sintering operation for the formation of a heating element is to be performed with the end faces of plated-through holes in the exposed state, it will be necessary to sputter a hardly oxidizable metal such as nickel. More preferably, a brazed gold of Au-Ni can be covered.
(2) Then, as shown in Fig. 10 (b), the laminate is hot-pressed to sinter the green sheet and conductive paste.
   The preferred sintering temperature is 1000 to 2000°C and the preferred sintering pressure is 100 to 200 kg/cm². This application of heat and pressure is carried out in an inert gas atmosphere. The inert gas that can be used for this purpose includes argon gas and nitrogen gas, among others. By the above procedure, plated-through holes 16 and 17, guard electrodes 5 and ground electrodes 6 are constructed.
(3) Then, as shown in Fig. 10 (c), channels 7 is formed on the surface of the sintered compact. The channels 7 are formed by means of a drill or by sand blasting, for instance.
(4) Then, as shown in Fig. 10 (d), the conductive paste is printed on the bottom side of the sintered compact and fired to construct a heating element 41.
(5) Then, as shown in Fig. 11 (e), the surface on which the silicon wafer is to be set (the surface formed with channels) is sputtered with titanium, molybdenum, nickel or the like, followed by deposition of nickel by electroless plating to complete a chuck top conductor layer 2. Simultaneously with the latter operation, a protective layer 410 is formed on the surface of the heating element 41, too, by nickel electroless plating.
(6) Then, as shown in Fig. 11 (f), suction holes 8 extending from the channels 7 to the reverse side and blind holes 180 for connection to external terminals are provided.
   The internal wall of the blind hole is preferably rendered conductive at least in part and the conductive internal wall is preferably connected to the guard electrode, the ground electrode or the like.
(7) Finally, as shown in Fig. 11 (g), a solder paste is printed on the connective regions of the surface of the heating element 41 and with external pins 191 set in position, heated for reflow. The preferred heating temperature is 200 to 500°C.

The external terminals 19 and 190 are also equipped for the blind holes 180 via brazed gold. Where necessary, bottomed holes can be formed and thermocouples be embedded therein.

The solder which can be used includes silver-lead, lead-tin, bismuth-tin and other alloy solders. The thickness of the solder layer is preferably 0.1 to 50 µm. Within this thickness range, an effective solder joint can be established.

While the wafer prober 101 [Fig. 1] was referred to as the objective product in the above description, said heating element can be printed on the green sheet to provide a wafer prober 201 [Fig. 5]. For the manufacture of the wafer prober 301 [Fig. 6], metal sheets to serve as said guard electrode and ground electrode and a metal wire to serve as said heating element may be embedded in a ceramic powder and the powder be sintered.

For the manufacture of the wafer prober 401 [Fig. 7], a Peltier device maybe attached via a thermal-sprayed metal layer.

### BEST MODE FOR CARRYING OUT THE INVENTION

The present invention is now described in further detail.

### Example 1

### Production of wafer prober 101 [Fig. 1]

(1) A composition comprising 100 weight parts of aluminum nitride powder (Tokuyama Co., mean particle diameter; 1.1 µm), 4 weight parts of yttria (mean particle diameter; 0.4 µm), 11.5 weight parts of acrylic binder, 0.5 weight part of dispersant and 53 weight parts of alcohol (1-butanol and ethanol) was molded by the doctor blade method to provide a 0.47 mm-thick green sheet.
(2) After this green sheet was dried at 80°C for 5 hours, through holes for the plated-through holes for connecting the heating element to external terminal pins were pierced by punching.
(3) A conductive paste A was prepared by mixing 100 weight parts of a tungsten carbide powder having a mean particle diameter of 1 µm, 3.0 weight parts of acrylic binder, 3.5 weight parts of the solvent α-terpineol and 0.3 weight part of dispersant.
   A conductive paste B was also prepared by mixing 100 weight parts of a tungsten powder having a mean particle diameter of 3 µm, 1.9 weight parts of acrylic binder, 3.7 weight parts of the solvent α-terpineol and 0.2 weight part of dispersant.
   Then, a guard electrode grid pattern print 50 and a ground electrode grid pattern print 60 were formed on the green sheet by screen printing with the above conductive paste A.
   In addition, the through holes for said plated-through holes for connection to terminal pins were filled with the above conductive paste B.
   Then, 50 printed and unprinted green sheets were alternately laid up and bonded together at 130°C and 80 kg/cm² to provide a laminate [Fig. 10 (a)].
(4) This laminate was then degreased in nitrogen gas at 600°C for 5 hours and, then, hot-pressed at 1890°C and 150 kg/cm² for 3 hours to provide a 4 mm-thick aluminum nitride plate. From this plate, a disk with a diameter of 230 mm was cut out to provide a ceramic plate [Fig. 10 (b)]. The size of each plated-through hole 16 and 17 were 3.0 mm in diameter and 3.0 mm deep.
   Each thickness of the guard electrode 5 and ground electrode 6 was 10 µm, and the location of the guard electrode 5 was 1.2 mm away from the wafer-mounting surface and the location of the ground electrode 6 was 3.0 mm away from the wafer-mounting surface.
(5) The plate obtained in the above step (4) was polished with a diamond wheel, and with a mask set in position, blasting with SiC or the like was performed to provide the surface with cavities for accommodating thermocouples (not shown) and a plurality of channels 7 (0.5 mm wide x 0.5 mm deep) for attraction of a silicon wafer by suction [Fig. 10 (c)].
(6) Then, a heating element 41 was printed on the side opposite to the wafer-mounting side. This printing was carried out using a conductive paste. The conductive paste used here was Solbest PS603D from Tokuriki Chemical Research Institute, which is generally used for the formation of plated-through holes in printed circuit boards. This conductive paste was a silver/lead paste containing 7.5 weight parts of a metal oxide component (comprising lead oxide, zinc oxide, silica, boron oxide and alumina in a weight ratio of 5/55/10/25/5) based on 100 weight parts of silver.
   The silver had a mean particle diameter of 4.5 µm and was flaky.
(7) The heater plate printed with the conductive paste as above was heated at 780°C to sinter the silver and lead in the conductive paste and print the paste onto the ceramic substrate 3. The heater plate was then immersed in a nickel electroless plating bath comprising an aqueous solution of nickel sulfate (30 g/L), boric acid (30 g/L), ammonium chloride (30 g/L) and Rochelle salt (60 g/L) to deposit a 1 µm-thick nickel layer 410 with a boron content of not more than 1 weight % on the surface of the sintered silver 41. Then, this heater plate was subjected to annealing at 120°C for 3 hours.
   The heating element comprising sintered silver was 5 µm in thickness and 2.4 mm wide and had an area resistivity of 7.7 mΩ/□ (milli ohm per square) (Fig. 10 (d)).
(8) The surface formed with channels 7 were serially sputtered to deposit a titanium layer; a molybdenum layer and a nickel layer. As the sputtering equipment, Japan Vacuum Technology's SV-4540 was used. The sputtering conditions were; gas pressure: 0.6 Pa, temperature: 100°C and power: 200 W. The sputtering time was adjusted for each metal species within the range of 30 seconds to 1 minute.
   The thicknesses of the films formed were determined from the image outputs of a fluorescent X-ray analyzer. Thus, the thickness of the titanium layer was 0.3 µm, that of the molybdenum layer was 2 µm, and that of the nickel layer was 1 µm.
(9) Using a nickel electroless plating bath comprising an aqueous solution of nickel sulfate (30 g/L), boric acid (30 g/L), ammonium chloride (30 g/L) and Rochelle salt (60 g/L) and a nickel electroplating bath comprising nickel sulfate (250 to 350 g/L), nickel chloride (40 to 70 g/L) and boric acid (30 to 50 g/L) and adjusted to pH 2.4 to 4.5 with sulfuric acid, the ceramic board obtained in the above step (8) was immersed to deposit a 7 µm-thick nickel layer with a boron content of not more than 1 weight % on the surface of said sputtered metal layer and the nickel layer so formed was annealed at 120°C for 3 hours.
   The surface of the heating element did not allow a current flow and, therefore, was not covered with electroplated nickel.
   Then, the board was immersed in a gold electroless plating solution containing potassium gold cyanide (2 g/L), ammonium chloride (75 g/L), sodium citrate (50 g/L) and sodium hypophosphite (10 g/L) at 93°C for 1 minute to form a 1 µm-thick gold layer on the plated nickel layer 15 [Fig. 11 (e)].
(10) Air suction holes 8 extending from the channels 7 to the reverse side of the board were drilled and blind holes 180 for exposing the plated-through holes 16 and 17 were further provided [Fig. 10 (f)]. The blind holes 180 were filled with a brazed gold of Ni-Au alloy (Au: 81.5 wt. %, Ni: 18.4 wt. %, impurity: 0.1 wt. %), which was then heated and caused to reflow at 970°C for connection to external terminal pins 19 and 190 of copal [Fig. 11 (g)]. Moreover, the heating element was provided with external pins 191 comprising copal via a solder layer (tin:lead = 9:1).
(11) Then, a plurality of thermocouples for temperature control were embedded in the cavities to provide a finished wafer prober 101 equipped with a heater.
(12) This wafer prober 101 was assembled with a stainless steel platform having a sectional configuration shown in Fig. 8 through a heat insulator 10 comprising ceramic fiber (Ibiden, Ibiwool™). This platform 11 was equipped with cooling gas ejection nozzles 12 for regulating the temperature of the wafer prober 101. Moreover, it was equipped with a suction hole 13 for aspirating the air necessary to attract the silicon wafer.

### Example 2

### Production of wafer prober 201 [Fig. 5]

(1) A composition comprising 100 weight parts of an aluminum nitride powder (Tokuyama Co., mean particle diameter; 1.1 µm), 4 weight parts of yttria (mean particle diameter; 0.4 µm), 11.5 weight parts of acrylic binder, 0.5 weight part of dispersant and 53 weight parts of alcohol (1-butanol and ethanol) was molded by the doctor blade method to provide a 0.47 mm-thick green sheet.
(2) After this green sheet was dried at 80°C for 5 hours, through holes for the plated-through holes for connecting the heating element to external terminal pins were pierced by punching.
(3) A conductive paste A was prepared by mixing 100 weight parts of a tungsten carbide powder having a mean particle diameter of 1 µm, 3.0 weight parts of acrylic binder, 3.5 weight parts of the solvent α-terpineol and 0.3 weight part of dispersant.
   A conductive paste B was also prepared by mixing 100 weight parts of a tungsten powder having a mean particle diameter of 3 µm, 1.9 weight parts of acrylic binder, 3.7 weight parts of the solvent α-terpineol and 0.2 weight part of dispersant.
   Then, a guard electrode grid pattern print and a ground electrode grid pattern print were formed on the green sheet by screen printing with the above conductive paste A. In addition, the heating element was printed in a concentric pattern as illustrated in Fig. 3.
   Furthermore, the through holes for said plated-through holes for connection to terminal pins were filled with the above conductive paste B.
   Then, 50 printed and unprinted green sheets were alternately laid up and bonded together at 130°C and 80 kg/cm² to provide a laminate.
(4) This laminate was then degreased in nitrogen gas at 600°C for 5 hours and, then, hot-pressed at 1890°C and 150 kg/cm² for 3 hours to provide a 3 mm-thick aluminum nitride plate. From this plate, a disk with a diameter of 230 mm was cut out to provide a ceramic board. The sizes of each plated-through hole were 2.0 mm in diameter and 3.0 mm deep.
   Each thickness of the guard electrode 5 and ground electrode 6 was 6 µm, and the location of the guard electrode 5 was 0.7 mm away from the wafer-mounting surface, the location of the ground electrode 6 was 1.4 mm away from the wafer-mounting surface, and the location of the heating element was 2.8 mm away from the wafer-mounting surface.
(5) The board obtained in the above step (4) was polished with a diamond wheel, and with a mask set in position, blasting with SiC or the like was performed to provide the surface with cavities for accommodating thermocouples (not shown) and a plurality of channels 7 (0.5 mm wide x 0.5 mm deep) for attraction of a silicon wafer by suction.
(6) The surface formed with channels 7 were serially sputtered to deposit a titanium layer, a molybdenum layer and a nickel layer. As the sputtering equipment, Japan Vacuum Technology's SV-4540 was used. The sputtering conditions were; gas pressure: 0.6 Pa; temperature: 100°C and power: 200 W. The sputtering time was adjusted for each metal species within the range of 30 seconds to 1 minute.
   The thicknesses of the films thus obtained were determined from the image outputs of a fluorescent X-ray analyzer. Thus, the thickness of the titanium layer was 0.5 µm, that of the molybdenum layer was 4 µm, and that of the nickel layer was 1.5 µm.
(7) The ceramic board 3 obtained in the above step (6) was immersed in a nickel electroless plating bath comprising an aqueous solution of nickel sulfate (30 g/L), boric acid (30 g/L), ammonium chloride (30 g/L) and Rochelle salt (60 g/L) to deposit a 7 µm-thick nickel layer with a boron content of not more than 1 weight % on the surface of said sputtered metal layer and the nickel layer so formed was annealed at 120°C for 3 hours.
   Then, the board was immersed in a gold electroless plating solution containing potassium gold cyanide (2 g/L), ammonium chloride (75 g/L), sodium citrate (50 g/L) and sodium hypophosphite (10 g/L) at 93°C for 1 minute to form a 1µm-thick plated gold layer on the plated nickel layer.
(8) Air suction holes 8 extending from the channels 7 to the reverse side of the board were drilled and blind holes 180 for exposing the plated-through holes 16 and 17 were further provided. The blind holes 180 were filled with a brazed gold of Ni-Au alloy (Au: 81.5 wt. %, Ni: 18.4 wt. %, impurity: 0.1 wt. %), which was then heated and caused to reflow at 970°C for connection to external terminal pins 19 and 190 comprising copal. The external terminals may comprise silicon wafer W.
(9) Then, a plurality of thermocouples for temperature control were embedded in the cavities to provide a wafer prober 201 equipped with a heater.
(10) This wafer prober 201 was assembled with a stainless steel platform having a sectional configuration shown in Fig. 9 through a heat insulator 10 comprising ceramic fiber (Ibiden, Ibiwool™). This platform 11 was formed with props 15 for preventing warpage of the wafer prober. It was also equipped with a suction hole 13 for aspirating the air to attract the silicon wafer by suction.

### Example 3

### Production of wafer prober 301 [Fig. 6]

(1) A10 µm-thick tungsten foil was punched to form a grid-like electrode.
   Two sheets of the grid electrode (which were to serve as a guard electrode 5 and a ground electrode 6, respectively) and a tungsten wire, as well as 100 weight parts of an aluminum nitride powder (Tokuyama Co., mean particle diameter: 1.1 µm) and 4 weight parts of yttria (mean particle diameter: 0.4 µm) were put in a mould and hot-pressed under nitrogen gas at 1890°C and 150 kg/cm² for 3 hours to prepare a 3 mm-thick aluminum nitride plate. From this plate, a disk with a diameter of 230 mm was cut out to provide a board. (2) This board was caused to go through the steps (5) to (10) of Example 2 to provide a wafer prober 301 and this wafer prober 301 was set on the platform 11 of Fig. 8 as in Example 1.

### Example 4

### Manufacture of wafer prober 401 [Fig. 7]

After the steps (1) to (5) and (8) to (10) of Example 1 were repeated, nickel thermal spraying was carried out on the surface opposite to the wafer-mounting surface. Then, a Peltier device of lead-tellurium system was attached to provide a wafer prober 401. As in Example 1, this wafer prober 401 was mounted on the platform 11 shown in Fig. 8.

### Example 5

### Manufacture of a wafer prober using silicon carbide as the ceramic substrate

Excepting the following particulars and conditions, the procedure of Example 3 was otherwise repeated to manufacture a wafer prober.

Thus, using 100 weight parts of a silicon carbide powder having a mean particle diameter of 1.0 µm, two grid electrodes (which were to serve as the guard electrode 5 and ground electrode 6, respectively) and a tungsten wire coated with a sol comprising 10 weight % of tetraethoxysilane, 0.5 weight % of hydrochloric acid and 89.5 weight % of wafer, the sintering was performed at the temperature of 1900°C. The sol mentioned above became SiO₂ on sintering to form an insulating layer.

Then, the wafer prober 301 thus obtained in Example 5 was mounted on the platform 11 illustrated in Fig. 8 as in Example 1.

### Example 6

### Manufacture of a wafer prober using alumina as the ceramic substrate

Except for the following particulars and conditions, the procedure of Example 1 was otherwise repeated to manufacture a wafer prober.

A composition prepared by mixing 100 weight parts of alumina powder (Tokuyama Co., mean particle diameter 1.5 µm), 11.5 weight parts of acrylic binder, 0.5 weight part of dispersant and 53 weight parts of alcohol (1-butanol and ethanol) was molded by the doctor blade method to provide a 0.5 mm-thick green sheet. The sintering temperature was 1000°C.

The wafer prober thus obtained in Example 6 was mounted on the platform 11 shown in Fig. 8 as in Example 1.

### Example 7

(1) A tungsten powder having a mean particle diameter of 3 µm was placed in a disk-shaped mould and hot-pressed under nitrogen gas at 1890°C and 150 kg/cm² for 3 hours to prepare a porous chuck top conductor layer of tungsten measuring 200 mm in diameter and 110 µm in thickness.
(2) Then, the steps (1) to (4) and (5) to (7) of Example 1 were repeated to provide a ceramic board equipped with the guard electrodes, ground electrodes and heating element.
(3) The porous chuck top conductor layer obtained in the above step (1) was mounted on the ceramic board through a brazed gold (same as the one used in the step (10) of Example 1) and heated for reflow at 970°C.
(4) The sequence of steps (10) to (12) of Example 1 was then repeated to provide a wafer prober.
   The wafer prober obtained in this example uniformly attracted a semiconductor wafer to its chuck top conductor layer.

### Comparative Example 1

Basically according to the method described in Japanese Kokoku Publication Hei-3-40947, a metallic wafer prober having the architecture shown in Fig. 12 was fabricated.

Thus, this wafer prober comprises a stainless steel disk measuring 230 mm in diameter and 15 mm in thickness, a mica layer 3B underneath said stainless steel disk and, as disposed further underneath said mica layer, a copper disk 100B measuring 230 mm in diameter and 20 mm in thickness. Further underneath the copper disk 100B, a Nichrome wire heating element 4B is attached via a mica layer 3B. The surface of the chuck top is formed with channels 7.

As in Example 1, the above wafer prober was mounted on the platform 11 illustrated in Fig. 8.

### Comparative Example 2

Except that a 1.5 mm-thick stainless steel sheet was used as chuck top 1B and, underneath thereof, a mica layer 3B and a 1.5 mm copper sheet 100B were disposed in that order, a metallic wafer prober was fabricated according to otherwise the same manner as the wafer prober of Comparative Example 1.

This wafer prober was mounted on the platform 11 of Fig. 8 as in Example 1.

### Evaluation method

On the wafer prober fabricated in each of the above examples and comparative examples, a silicon wafer W shown in Fig. 12 was set and a conductivity test was performed by pressing a probe card 601 under temperature control.

The time till the temperature had risen to 150°C was measured. In addition, the amount of warpage of the wafer prober upon being pressed by the probe card at a pressure of 15 kg/cm² was determined. The amount of warpage was measured with Kyocera form meter Nanoway™.

In the case of the wafer prober according to Example 2, it was first set on a platform equipped with anti-warpage props and measured for warpage and, then set on a prop-free platform shown in Fig. 8 and measured for warpage. The results are shown in Table 1.

**Table 1**

| | Warpage (µm) | Time (min.) |
|---|---|---|
| Example 1 | 1 | 3.0 |
| Example 2 | *1 0.5 | 2.9 |
| | *2 1 | 2.8 |
| Example 3 | 1.5 | 3.0 |
| Example 4 | 1.5 | 3.0 |
| Example 5 | 2.0 | 4.0 |
| Example 6 | 3.0 | 7.0 |
| Example 7 | 1 | 2.9 |
| Compar. Ex. 1 | 1 | 15 |
| Compar. Ex. 2 | 15 | 5 |

| | | |
|---|---|---|
| Note *1: With props | | |
| *2: Without props | | |

### INDUSTRIAL APPLICABILITY

As described above, the wafer prober of the present invention is not only light in weight and excellent in thermal response kinetics, but also free from warping upon pressing with a probe card, so that breakage of silicon wafers and measurement errors can be effectively prevented.

## Claims

1. A wafer prober which comprises a ceramic substrate and a conductor layer formed on the surface thereof.

2. The wafer prober according to Claim 1 wherein said conductor layer is a chuck top conductor layer.

3. The wafer prober according to Claim 1 or 2 wherein said ceramic substrate is equipped with a temperature control means.

4. The wafer prober according to any of Claims 1 to 3 wherein said ceramic substrate is composed of at least one member selected from the group essentially consisting of nitride ceramics, carbide ceramics and oxide ceramics.

5. The wafer prober according to any of Claims 1 to 4 wherein said temperature control means is a Peltier device.

6. The wafer prober according to any of Claims 1 to 5 wherein said temperature control means is a heating element.

7. The wafer prober according to any of Claims 1 to 6 wherein said ceramic substrate has at least one conductor layer therein.

8. The wafer prober according to any of Claims 1 to 7 wherein said ceramic substrate is formed with a channel on its surface.

9. The wafer prober according to any of Claims 1 to 8 wherein channels are formed on the surface of said ceramic substrate, the channels being provided with air suction holes.

10. The wafer prober according to Claim 1 wherein said conductor layer is a porous layer.
